# EUROPÄISCHE PATENTANMELDUNG

(11) **EP 2 799 703 A1**
(43) Veröffentlichungstag der Anmeldung: **05.11.2014**
(21) Anmeldenummer: 14172402.1
(22) Anmeldetag: 20.07.2010
(51) Int. Cl.: F02M 51/00, H01L 41/047, H01L 41/053, H01L 41/083

(54) **Piezoaktor mit elektrischer Kontaktierung**

(30) Priorität: 21.07.2009 DE 102009034099
(62) Teilanmeldung aus: 10734999.5
(71) Anmelder: EPCOS AG, 81669 München (DE)
(72) Erfinder: Gabl, Reinhard, 6330 Kufstein (AT); Reszat, Jan-Thorsten, 76137 Karlsruhe (DE); Laussermayer, Markus, 8521 Wettmannstätten (AT)
(74) Vertreter: Epping - Hermann - Fischer

(57) **Zusammenfassung**

Die vorliegende Erfindung betrifft einen Piezoaktor (10) in Vielschichtbauweise, bei dem piezoelektrische Schichten (14) und Elektrodenschichten (12) alternierend übereinander zu einem Stapel (16) angeordnet sind. Mehrere der Elektrodenschichten (12) sind mit einem Kontaktstift (24) elektrisch leitend verbunden, wobei am Kontaktstift (24) eine Weiterführung (30) elektrisch leitend angeordnet ist. Die Weiterführung (30) weist eine Kontaktstelle (32) mit dem Kontaktstift (24) sowie ein freies Ende (34) zur Herstellung eines elektrischen Anschlusses des Piezoaktors (10) auf. Eine Gerade, die durch die Kontaktstelle (32) und das freie Ende (34) der Weiterführung (30) verläuft schließt mit einer Längsachse (18) des Kontaktstifts (24) einen Winkel (p) ein, der größer ist als 0° und kleiner ist als 180°.

## Beschreibung

Es wird ein Piezoaktor in Vielschichtbauweise beschrieben, bei dem piezoelektrische Schichten und Elektrodenschichten alternierend übereinander zu einem Stapel angeordnet sind. Beim Anlegen einer elektrischen Spannung an die Elektrodenschichten dehnt sich der Stapel entlang der aus der angelegten Spannung resultierenden elektrischen Feldrichtung aus.

Mittels eines solchen Piezoaktors wird beispielsweise ein Ventilkolben eines Steuerventils betätigt, welches als Einspritzventil in einem Kraftfahrzeug dient.

Ein Piezoaktor ist beispielsweise in den Druckschriften DE 199 45 933 C1 oder der WO 2005/035971 A1 beschrieben.

Es ist eine zu lösende Aufgabe, einen Piezoaktor anzugeben, welcher über eine hohe Zuverlässigkeit verfügt und für eine Vielzahl möglicher Anwendungsbereiche und Einbauorte geeignet ist.

Diese Aufgabe wird durch den unabhängigen Anspruch gelöst.

Vorteilhafte Ausgestaltungen und Weiterbildungen der Erfindung ergeben sich aus den abhängigen Ansprüchen.

Es wird ein Piezoaktor in Vielschichtbauweise angegeben, bei dem piezoelektrische Schichten und Elektrodenschichten alternierend übereinander zu einem Stapel angeordnet sind. Der Stapel weist beispielsweise vier Seitenflächen und zwei Stirnflächen auf. Der Piezoaktor kann an den Stirnflächen eingespannt sein, was für eine mechanische Vorspannung entlang der Längsachse des Stapels sorgt.

Beispielsweise umfasst der Stapel eine Vielzahl dünner Folien aus Piezokeramik, welche beispielsweise ein Material wie Bleizirkonattitanat umfassen. Eine piezoelektrische Schicht kann eine oder mehrere dieser Folien aufweisen. Zwischen diesen Schichten aus Piezokeramik sind Elektrodenschichten angeordnet. Je nach dem gewünschten spannungsabhängigen Verhalten des Piezoaktors muss nicht unbedingt auf jede piezoelektrische Schicht eine Elektrodenschicht folgen.

Ein mögliches Material für die Elektrodenschicht ist Silberpalladium oder Kupfer. Dieses kann als Paste mittels eines Siebdruckverfahrens auf die piezoelektrische Schicht aufgebracht werden und anschließend kann der Stapel gesintert werden.

Die Elektrodenschichten können durchgehend auf die piezoelektrischen Schichten aufgebracht sein oder sie können die Querschnittsfläche der piezoelektrischen Schichten nur teilweise bedecken. Die Ausführungsform der elektrischen Kontaktierung der Elektrodenschichten hängt davon ab, ob die Elektrodenschichten durchgehend auf der Oberfläche der piezoelektrischen Schichten angeordnet sind.

Mehrere der Elektrodenschichten sind mit einem Kontaktstift elektrisch leitend verbunden. Am Kontaktstift kann eine Weiterführung so angeordnet sein, dass sie den Kontaktstift und die Weiterführung elektrisch leitend verbindet. Insbesondere weist die Weiterführung eine Kontaktstelle mit dem Kontaktstift auf. Die Kontaktstelle ist dazu ausgelegt, die Weiterführung mit dem Kontaktstift elektrisch leitend zu verbinden. Die Weiterführung weist ein freies Ende auf, welches zur Herstellung eines elektrischen Anschlusses vorgesehen ist. Eine Gerade, welche durch die Kontaktstelle und das freie Ende der Weiterführung verläuft, schließt einen Winkel mit der Längsachse des Kontaktstifts ein, der größer als 0° und kleiner als 180° ist.

In einer Ausführungsform ist die Kontaktstelle zur Herstellung der Verbindung zwischen der Weiterführung und des Kontaktstifts entlang des Stapels aus piezoelektrischen Schichten und Elektrodenschichten angeordnet. Insbesondere ist die Kontaktstelle zwischen einem oberen Ende und einem unteren Ende des Stapels angeordnet.

In einer Ausführungsform, in der die Elektrodenschichten durchgehend ausgeführt sind, führen die aufgebrachten Elektrodenschichten an allen Seitenflächen des Stapels aus diesem heraus. Die elektrische Verbindung der Elektrodenschichten mit dem Kontaktstift kann zum Beispiel durch dünne Drähte realisiert sein, die jede zweite Elektrodenschicht an einer Seitenfläche des Stapels einzeln mit dem Kontaktstift verbinden.

An dem Kontaktstift kann eine Weiterführung angebracht sein. Diese Weiterführung ist mit dem Kontaktstift an einer Kontaktstelle elektrisch leitend verbunden. Beispielsweise ist die Weiterführung fest mit dem Kontaktstift verbunden, zum Beispiel an diesem angelötet oder mittels einer Öse, welche den Kontaktstift fest umschließt, am Kontaktstift befestigt.

Alle anderen Befestigungsmöglichkeiten, die einen leitenden Kontakt zwischen dem Kontaktstift und der Weiterführung ermöglichen und die ausreichende Stabilität hinsichtlich eines elektrischen Anschlusses bietet, sind jedoch ebenfalls denkbar.

Die Weiterführung umfasst beispielsweise einen flexiblen Leitungsdraht. Vorzugsweise umfasst die Weiterführung ein starres stiftförmiges Element. Eine Kombination aus diesen beiden Möglichkeiten wäre ebenso denkbar.

Die Weiterführung ist am Kontaktstift angebracht. Der Winkel, in dem die Weiterführung am Kontaktstift angebracht ist, soll zwischen 0° und 180° bezüglich der Längsachse des Kontaktstifts betragen. Durch die Möglichkeit verschiedene Winkel zu wählen, kann eine individuelle Ausrichtung der elektrischen Anschlüsse erreicht werden und eine seitliche Weiterkontaktierung des Stapels über die Weiterführung wird ermöglicht.

Das freie Ende der Weiterführung kann vom Zentrum des Stapels gesehen nach außen weisend ausgerichtet sein. Dieses freie Ende kann zum Anlegen einer Spannung zwischen den Elektrodenschichten dienen und somit einen elektrischen Anschluss des Stapels bilden.

Vorzugsweise führen die Elektrodenschichten abwechselnd an gegenüberliegenden Seitenflächen aus dem Stapel heraus und mehrere der Elektrodenschichten sind mittels einer Außenelektrode, welche seitlich am Stapel aufgebracht ist, kontaktiert.

Bei einem Stapel, in dem die Elektrodenschichten wechselseitig aus diesem herausführen, bedecken die Elektrodenschichten nicht die ganze Fläche einer piezoelektrischen Schicht. Die Bereiche des Stapels in denen sich benachbarte Elektrodenschichten in Stapelrichtung nicht überlappen, werden inaktive Zonen genannt. Die Bereiche des Stapels, in denen sich benachbarte Elektrodenschichten in Stapelrichtung überlappen, werden aktive Zonen genannt.

Eine solche Konstruktion des Stapels erlaubt beispielsweise eine gemeinsame elektrische Kontaktierung aller Elektrodenschichten, die an derselben Seite aus dem Stapel herausführen, über eine gemeinsame Außenelektrode.

Die Außenelektrode wird beispielsweise mittels einer Einbrennpaste, die durch ein Siebdruckverfahren auf die Außenseite des Stapels aufgebracht ist, hergestellt und anschließend mit dem Stapel gesintert.

In einer vorteilhaften Ausführungsform ist der Kontaktstift parallel zur Längsachse des Stapels angeordnet.

Da an dem Kontaktstift die Weiterführung befestigt ist, folgt aus einer festen Orientierung des Kontaktstifts bezüglich des Stapels auch eine feste Orientierung der Weiterführung zu dem Stapel. Insbesondere ist in diesem Fall der Winkel zwischen dem Kontaktstift und der Weiterführung fest. Dies kann sehr hilfreich sein, um die Lage des freien Endes der Weiterführung und somit den späteren elektrischen Anschluss des Piezoaktors einzustellen, da nur der Winkel der Weiterführung bezüglich des Kontaktsstifts berücksichtigt werden muss und nicht der Winkel zwischen der Weiterführung und der Längsachse des Stapels.

Bei der Herstellung des Piezoaktors kann auch der Kontaktstift mit einer Weiterführung schon vorgefertigt worden sein und das so entstandene Bauteil kann in einem einzigen Arbeitsschritt beispielsweise über ein Zwischenelement am Stapel angebracht werden. Dadurch, dass die Orientierung der Weiterführung bezüglich des Kontaktstifts schon feststeht, ist bei einer parallelen Anordnung auch zwischen Kontaktstift und Stapel die Orientierung der Weiterführung bezüglich des Stapels festgelegt.

Außerdem ist eine parallele Orientierung des Kontaktstifts bezüglich des Stapels platzsparend.

In einer weiteren vorteilhaften Ausführungsform ist ein elektrisch leitendes Zwischenelement zwischen der Außenelektrode und dem Kontaktstift angeordnet, welches die Außenelektrode und den Kontaktstift elektrisch leitend verbindet.

Das Zwischenelement kann ein oder mehrere Einzelelemente umfassen. Beispielsweise kann es sich um ein elastisches Bauteil handeln, welches sich den Bewegungen des Stapels anpasst. Dies verhindert einen Verlust der elektrischen Verbindung zwischen der Außenelektrode und dem Kontaktstift und sorgt für eine beständige Betriebsfähigkeit des Piezoaktors. Insbesondere kann das Abreißen der Verbindung zwischen Kontaktstift und Zwischenelement und zwischen Zwischenelement und Außenelektrode verhindert werden.

Durch ein solches Abreißen der elektrischen Verbindung zwischen dem Kontaktstift und den Elektrodenschichten könnte ein Ausfall des Piezoaktors erfolgen. Sollte der Piezoaktor beispielsweise einen Ventilkolben eines Steuerventils betätigen, welches als Einspritzventil in einem Kraftfahrzeug dient, dann muss der Piezoaktor umgehend ausgetauscht werden, um einen weiteren Betrieb des Einspritzventils und somit des Motors zu gewährleisten.

Weiterhin kann vorgesehen sein, dass das elektrisch leitende Zwischenelement parallel angeordnete Drähte umfasst, welche die Außenelektrode mit dem Kontaktstift elektrisch leitend verbindet. Beispielsweise können die parallelen Drähte senkrecht zur Längsachse des Stapels ausgerichtet sein. Um die Außenelektrode mit dem Kontaktstift elektrisch leitend zu verbinden, findet beispielsweise eine sogenannte Drahtharfe Verwendung. Diese umfasst eine Mehrzahl dünner, elektrisch leitfähiger Drähte. Der Draht kann mit der Außenelektrode und dem Kontaktstift verlötet sein.

Beispielsweise können zwei Außenelektroden am Stapel angebracht sein, die abwechselnd die Elektrodenschichten kontaktieren. Zur Herstellung der Drahtharfe wird ein dünner, elektrisch leitfähiger Draht in einer Vielzahl von Windungen um den Stapel gewickelt. Nach dem Verlöten des Drahtes mit den Außenelektroden kann die Drahtverbindung zwischen den beiden Außenelektroden durchtrennt und die Verbindung vollständig entfernt werden. Somit sind die Außenelektroden voneinander elektrisch isoliert.

Vorzugsweise schließt die Gerade, die durch die Kontaktstelle zwischen der Weiterführung und dem Kontaktstift und das freie Ende der Weiterführung verläuft, mit der Längsachse des Kontaktstifts einen Winkel von 90° ein.

Die Weiterführung kann senkrecht zum Kontaktstift angeordnet sein. Falls der Kontaktstift auch parallel zur Längsachse des Stapels angeordnet ist, dann ist die Weiterführung nicht nur senkrecht zum Kontaktstift sondern auch senkrecht zur Längsachse des Stapels angeordnet. Diese Orientierung ist für einen Anschluss des Piezoaktors an eine Spannungsquelle vorteilhaft, da auch eine seitliche elektrische Weiterkontaktierung des Piezoaktors auf diese Weise möglich ist.

In einer vorteilhaften Ausführungsform weist der Piezoaktor ein Gehäuse auf.

Dieses Gehäuse kann beispielsweise ein Verguss aus einem elastischen Material, wie zum Beispiel Silikon sein oder einen derartigen Verguss umfassen. Idealerweise umschließt das Gehäuse mindestens die Seitenflächen des Stapels. Auch alle anderen Gehäuseformen, die einen Betrieb des Piezoaktors nicht behindern, sind denkbar. Ein Gehäuse kann Schutz gegen Umwelteinflüsse wie beispielsweise Nässe bieten.

In einer weiteren vorteilhaften Ausführungsform ist der Kontaktstift vollständig vom Gehäuse umschlossen.

Da der Kontaktstift nicht mehr direkt zum Anschluss des Stapels an eine Spannungsquelle benötigt wird, kann es zweckmäßig sein, ihn komplett im Gehäuse zu belassen. Ein seitlicher Anschluss ist bei manchen Anwendungen von Vorteil, da die mechanischen Kontaktflächen, die sich beispielsweise an den Stirnseiten des Stapels befinden, von den elektrischen Anschlüssen getrennt sind.

Vorzugsweise ragt die Weiterführung aus einer Seitenfläche des Gehäuses heraus.

Auf diese Weise wird eine elektrische Weiterkontaktierung an einer Seitenfläche des Gehäuses ermöglicht.

Weiterhin kann vorgesehen sein, dass die Weiterführung an einem freien Ende mit einem Anschlusselement verbunden ist und der Piezoaktor über dieses Anschlusselement angesteuert werden kann.

Das Anschlusselement dient dazu, eine elektrische Spannung zwischen die Elektrodenschichten anzulegen. Über die Höhe der angelegten Spannung kann das Verhalten des Stapels geregelt werden. Bei dem Anschlusselement kann es sich um einen Aufsatz auf die Weiterführung handeln. Ein solcher Aufsatz kann an jeder Weiterführung aufgebracht sein. Auch können zwei Aufsätze in einem Bauteil integriert sein und gemeinsam ein Anschlusselement bilden.

Das Anschlusselement kann auch ein Teil einer elektrischen Weiterkontaktierung sein, die am Einbauort des Piezoaktors angeordnet ist. Die Weiterführungen können mit der Weiterkontaktierung beispielsweise über eine Steckverbindung verbunden sein. Über die Weiterkontaktierung kann eine Spannung an den Stapel angelegt und auch geregelt werden.

In einer vorteilhaften Ausführungsform weist der Piezoaktor zwei Kontaktstifte auf und die Elektrodenschichten sind abwechselnd mit jeweils einem Kontaktstift elektrisch leitend verbunden. Jeder der Kontaktstifte weist eine Weiterführung auf. Über die freien Enden der Weiterführungen kann eine Spannung zwischen benachbarten Elektrodenschichten angelegt werden.

Beispielsweise sind die Elektrodenschichten abwechselnd an gegenüberliegenden Seitenflächen des Stapels mit einem Kontaktstift verbunden. An dem Kontaktstift ist eine Weiterführung angebracht.

Im Falle durchgehender Elektrodenschichten kann jede zweite Elektrodenschicht mittels eines leitfähigen Drahtes mit einem Kontaktstift verbunden sein. Da am Kontaktstift eine Weiterführung angebracht ist, wird auf diese Weise eine elektrisch leitende Verbindung zwischen den Elektrodenschichten und der Weiterführung hergestellt.

Eine andere Möglichkeit wäre, über eine Außenelektrode und ein Zwischenelement eine leitfähige Verbindung zwischen den Elektrodenschichten und der Weiterführung herzustellen. Dies ist insbesondere für den Fall vorteilhaft, dass die Elektrodenschichten nicht die gesamte Querschnittsfläche der piezoelektrischen Schicht bedecken.

An die Weiterführungen kann dann über das Anschlusselement eine Spannung angelegt werden. Je nach der gewünschten Ausführung des Anschlusses kann die Weiterführung bezüglich der Längsachse des Stapels unterschiedlich orientiert sein.

Im Falle zweier Weiterführungen kann die Weiterkontaktierung in beliebiger Orientierung der Weiterführungen zueinander erfolgen. Dadurch kann der Piezoaktor individuell, je nachdem welche Orientierung der freien Enden der Weiterführungen gewünscht ist, angefertigt werden.

Beispielsweise können die freien Enden der Weiterführungen an derselben Seitenfläche des Piezoaktors angeordnet sein.

Eine solche Anordnung der freien Enden der Weiterführungen ist beispielsweise sehr platzsparend. In diesem Fall ist eine elektrische Weiterkontaktierung auch über nur eine Seitenfläche nötig. Dies ist oft aus Platzgründen bevorzugt und der Einbau eines solchen Piezoaktors ist unter Umständen leichter, als im Falle einer Anordnung der Weiterführungen an unterschiedlichen Seitenflächen.

Die freien Enden der Weiterführungen können übereinander bezüglich der Längsachse des Stapels angeordnet sind.

Dabei können die freien Enden der Weiterführungen in verschiedener Höhe des Stapels auf derselben Seitenfläche des Piezoaktors oder auch an verschiedenen Seitenflächen angeordnet sein.

In einer weiteren Ausführungsform sind die freien Enden der Weiterführung nebeneinander bezüglich der Längsachse des Stapels angeordnet.

Die freien Enden der Weiterführungen können auf gleicher Höhe an derselben Seitenfläche des Piezoaktors angeordnet sein oder auf der gleichen Höhe an verschiedenen Seitenflächen des Piezoaktors.

In einer vorteilhaften Ausführungsform sind die freien Enden der Weiterführungen an unterschiedlichen Seitenflächen des Piezoaktors angeordnet.

Eine solche Anordnung der freien Enden der Weiterführungen hat den Vorteil, dass die Weiterkontaktierung räumlich getrennt voneinander erfolgen kann.

Im Folgenden werden der angegebene Piezoaktor und seine bevorzugten Ausführungsformen anhand von schematischen und nicht maßstabsgetreuen Figuren erläutert. Es zeigen:
- Figur 1: einen Piezoaktor mit einem über ein Zwischenelement mit den Elektrodenschichten verbundenen Kontaktstift, an dem eine Weiterführung angebracht ist,
- Figur 2a: einen Querschnitt durch einen Piezoaktor mit zwei zur Längsachse des Stapels senkrecht angeordneten Weiterführungen,
- Figur 2b: einen Querschnitt durch einen Piezoaktor mit zwei Weiterführungen, welche an gegenüberliegenden Seiten des Stapels angeordnet sind,
- Figur 3a: eine Seitenansicht des Piezoaktors wie er in Figur 2a gezeigt ist,
- Figur 3b: eine Seitenansicht des Piezoaktors wie er in Figur 2b gezeigt ist und
- Figur 3c: eine Seitenansicht eines Piezoaktors mit zwei bezüglich der Längsachse des Piezoaktor übereinander angeordneten Weiterführungen.

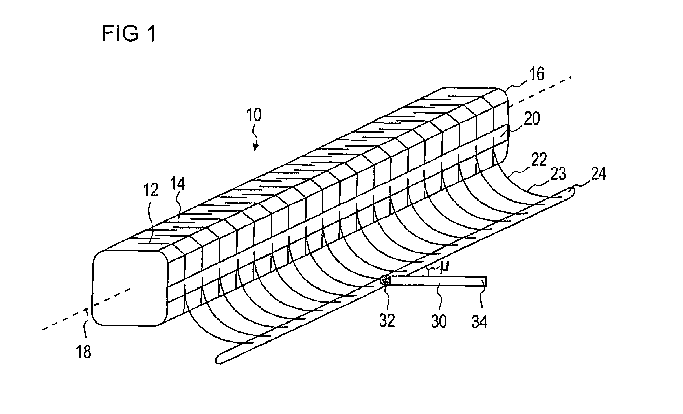

Figur 1 zeigt schematisch einen Piezoaktor 10. Deutlich sind die Elektrodenschichten 12 zu erkennen, welche in der hier dargestellten Ausführung wechselseitig aus dem Stapel 16 führen. An den gegenüberliegenden Seiten des Stapels 16 ist eine Außenelektrode 20 angebracht, wobei in der hier verwendeten Ansicht nur eine Außenelektrode 20 zu sehen ist.

An der Außenelektrode 20 ist ein leitendes Zwischenelement 22 angeordnet, welches aus dünnen leitenden Drähten 23 gebildet ist. Diese parallel zueinander angeordneten Drähte 23 verbinden die Außenelektrode 20 mit einem starren Kontaktstift 24. An diesem starren Kontaktstift 24 ist eine Weiterführung 30, welche aus einem metallischen Stift besteht, fest angelötet. Der Kontaktstift 24 ist parallel zur Längsachse 18 des Stapels 16 angeordnet.
Der Punkt, an dem der elektrische Kontakt zwischen der Weiterführung 30 und dem Kontaktstift 24 hergestellt ist, ist die Kontaktstelle 32. Das freie Ende 34 der Weiterführung 30 zeigt in eine dem Stapel 16 abgewandte Richtung.

Legt man eine Gerade durch die Kontaktstelle 32 und das freie Ende 34 der Weiterführung 30, so schließt diese Gerade mit der Längsachse 18 des Kontaktstifts 24 einen Winkel µ ein, der in dem dargestellten Beispiel 90° beträgt.

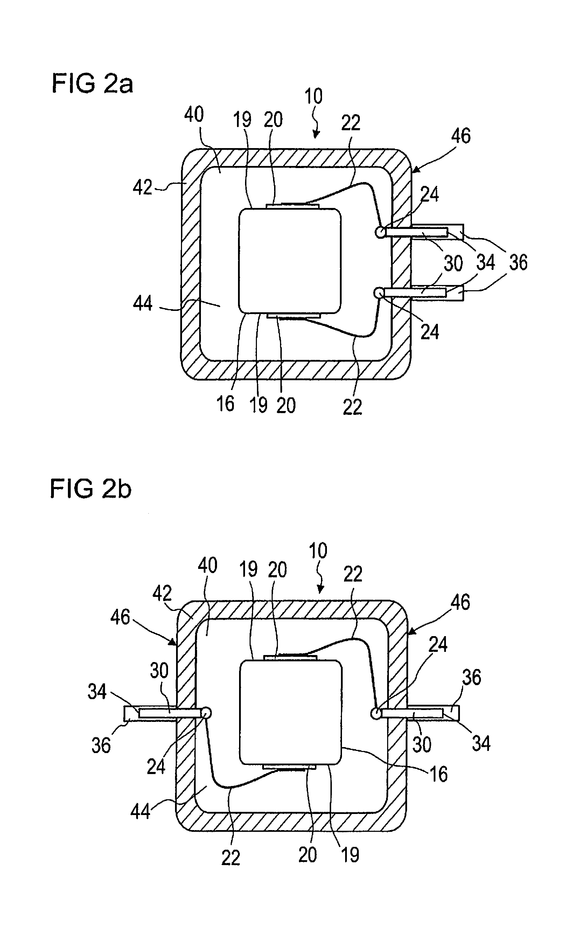

Figur 2a zeigt einen Querschnitt senkrecht zur Längsachse 18 eines Piezoaktors 10 mit zwei senkrecht zur Längsachse 18 des Stapels 16 angeordneten Weiterführungen 30.

In der Mitte der Abbildung ist der Stapel 16 zu sehen, an dem an zwei einander gegenüberliegenden Seitenflächen 19 jeweils eine Außenelektrode 20 aufgebracht ist. Diese Außenelektroden 20 sind über ein gebogenes Zwischenelement 22 leitend mit jeweils einem Kontaktstift 24 verbunden.

Am Kontaktstift 24 ist elektrisch leitend eine Weiterführung 30 angelötet. Um diese Anordnung ist eine Vergussmasse 42 gespritzt, welche zusammen mit einer Hülse 44 das Gehäuse 40 des Piezoaktors 10 bildet. Die Vergussmasse 42 kann ein elastisches Material, wie zum Beispiel Silikon, umfassen.

An der rechten Seite von Figur 2a ist zu sehen, dass nur die beiden Weiterführungen 30 aus dem Gehäuse 40 herausragen. An die freien Enden 34 der Weiterführungen 30 sind Anschlusskontakte 36 angebracht, über die eine Spannung an die Elektrodenschichten 12 im Piezoaktor 10 angelegt ist. Die Weiterführungen 30 ragen an derselben Seitenfläche 46 aus dem Gehäuse 40 heraus.
Figur 2b zeigt einen ähnlichen Aufbau wie in Figur 2a mit dem Unterschied, dass die Weiterführungen 30 an gegenüberliegenden Seitenflächen 46 des Gehäuses 40 aus diesem herausragen.

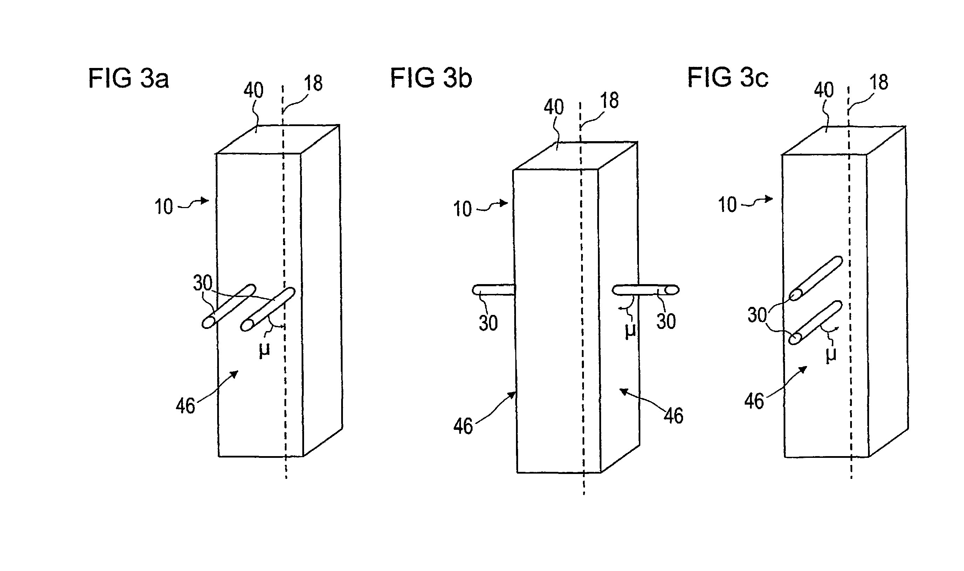

Figur 3a zeigt eine Seitenansicht des Piezoaktors 10, wie er bereits im Querschnitt in Figur 2a gezeigt ist. Deutlich ist zu sehen, dass die Weiterführungen 30 im Winkel µ = 90° zur Längsachse 18 des Piezoaktors 10 hin angeordnet sind.

Ebenfalls ist zu sehen, dass die Weiterführungen 30 nebeneinander senkrecht zur Längsachse 18 des Piezoaktors 10 angeordnet sind.

Figur 3b zeigt eine Seitenansicht des Piezoaktors 10, wie er bereits im Querschnitt in Figur 2b gezeigt ist. Deutlich ist zu sehen, dass die Weiterführungen 30 im Winkel µ = 90° zur Längsachse 18 des Piezoaktors 10 hin angeordnet sind.

Ebenfalls ist zu sehen, dass die Weiterführungen 30 an gegenüberliegenden Seitenflächen 46 aus dem Gehäuse 40 des Piezoaktors 10 auf gleicher Höhe aus diesem herausführen.

Figur 3c zeigt eine Seitenansicht eines Piezoaktors 10. Ebenso wie in Figur 3a führen die Weiterführungen 30 an der gleichen Seitenfläche 46 des Gehäuses 40 aus diesem heraus. In diesem Beispiel sind sie jedoch übereinander senkrecht entlang der Längsachse 18 angeordnet.

Die Erfindung ist nicht auf die vorstehend beschriebenen bevorzugten Ausführungsbeispiele beschränkt. Vielmehr ist eine Vielzahl von Varianten und Abwandlungen möglich, die ebenfalls von dem Erfindungsgedanken Gebrauch machen und deshalb in den Schutzbereich fallen.

### Bezugszeichenliste:

- 10: Piezoaktor
- 12: Elektrodenschicht
- 14: piezoelektrische Schicht
- 16: Stapel
- 18: Längsachse
- 19: Seitenfläche des Stapels

- 20: Außenelektrode
- 22: Zwischenelement
- 23: Draht
- 24: Kontaktstift

- 30: Weiterführung
- 32: Kontaktstelle
- 34: freies Ende der Weiterführung
- 36: Anschlusselement

- 40: Gehäuse
- 42: Verguss
- 44: Hülse
- 46: Seitenfläche des Gehäuses

- µ: Winkel zwischen einer Geraden die durch den Kontaktpunkt und das freie Ende der Weiterführung läuft und dem Kontaktstift

## Patentansprüche

1. Piezoaktor in Vielschichtbauweise, bei dem piezoelektrische Schichten (14) und Elektrodenschichten (12) alternierend übereinander zu einem Stapel (16) angeordnet sind, wobei mehrere der Elektrodenschichten (12) mit einem Kontaktstift (24) elektrisch leitend verbunden sind, wobei am Kontaktstift (24) eine Weiterführung (30) angeordnet ist, welche eine Kontaktstelle (32) aufweist zur Herstellung einer elektrisch leitenden Verbindung mit dem Kontaktstift (24) und wobei die Weiterführung (30) ein freies Ende (34) aufweist zur Herstellung eines elektrischen Anschlusses des Piezoaktors (10), und wobei eine Gerade, die durch die Kontaktstelle (32) und das freie Ende (34) der Weiterführung (30) verläuft mit einer Längsachse (18) des Kontaktstifts (24) einen Winkel (p) einschließt, der größer ist als 0° und kleiner ist als 180°,
wobei der Kontaktstift (24) starr ist und an dem starren Kontaktstift (24) die Weiterführung (30), welche aus einem metallischen Stift besteht, angelötet ist.

2. Piezoaktor nach Anspruch 1, wobei die Elektrodenschichten (12) abwechselnd an gegenüberliegenden Seitenflächen (19) aus dem Stapel (16) herausführen und wobei mehrere der Elektrodenschichten (12) mittels einer Außenelektrode (20), welche seitlich am Stapel (16) aufgebracht ist, kontaktiert sind.

3. Piezoaktor nach Anspruch 1 oder 2, wobei der Kontaktstift (24) parallel zur Längsachse (18) des Stapels (16) angeordnet ist.

4. Piezoaktor nach Anspruch 2 oder 3, wobei ein elektrisch leitendes Zwischenelement (22) zwischen der Außenelektrode (20) und dem Kontaktstift (24) angeordnet ist und diese elektrisch leitend verbindet.

5. Piezoaktor nach Anspruch 4, wobei das elektrisch leitende Zwischenelement (22) parallel angeordnete Drähte umfasst, welche die Außenelektrode (20) mit dem Kontaktstift (24) elektrisch leitend verbinden.

6. Piezoaktor nach einem der vorhergehenden Ansprüche, wobei die Gerade, die durch die Kontaktstelle (32) zwischen der Weiterführung (30) und dem Kontaktstift (24) und das freie Ende (34) der Weiterführung (30) verläuft, mit der Längsachse (18) des Kontaktstifts (24) einen Winkel (p) von 90° einschließt.

7. Piezoaktor nach einem der vorhergehenden Ansprüche, der ein Gehäuse (40) aufweist.

8. Piezoaktor nach Anspruch 7, wobei der Kontaktstift (24) vollständig vom Gehäuse (40) umschlossen ist.

9. Piezoaktor nach Anspruch 7 oder 8, wobei die Weiterführung (30) aus einer Seitenfläche (46) des Gehäuses (40) herausragt.

10. Piezoaktor nach einem der vorhergehenden Ansprüche, wobei die Weiterführung (30) an dem freien Ende (34) mit einem Anschlusselement (36) verbunden ist und wobei der Piezoaktor (10) über das Anschlusselement (36) angesteuert werden kann.

11. Piezoaktor nach einem der vorhergehenden Ansprüche, wobei der Piezoaktor (10) zwei Kontaktstifte (24) aufweist und wobei die Elektrodenschichten (12) abwechselnd mit jeweils einem der Kontaktstifte (24) elektrisch leitend verbunden sind und jeder der Kontaktstifte (24) eine Weiterführung (30) aufweist und wobei über die freien Enden (34) der Weiterführungen (30) eine Spannung zwischen benachbarten Elektrodenschichten (12) des Stapels (16) angelegt werden kann.

12. Piezoaktor nach Anspruch 11, wobei die freien Enden (34) der Weiterführungen (30) an derselben Seitenfläche (19) des Piezoaktors (10) angeordnet sind.

13. Piezoaktor nach Anspruch 12, wobei die freien Enden (34) der Weiterführungen (30) übereinander bezüglich der Längsachse (18) des Stapels (16) angeordnet sind.

14. Piezoaktor nach Anspruch 12, wobei die freien Enden (34) der Weiterführungen (30) nebeneinander bezüglich der Längsachse (18) des Stapels (16) angeordnet sind.

15. Piezoaktor nach Anspruch 11, wobei die freien Enden (34) der Weiterführungen (30) an unterschiedlichen Seitenflächen (19) des Piezoaktors (10) angeordnet sind.
